# EUROPÄISCHE PATENTSCHRIFT

(11) **EP 3 232 751 B1**
(45) Veröffentlichungstag und Bekanntmachung des Hinweises auf die Patenterteilung: **18.07.2018**
(21) Anmeldenummer: 16164804.3
(22) Anmeldetag: 12.04.2016
(51) Int. Cl.: H05K 7/20, H01R 13/66, H05K 9/00, H01R 13/6594, H05K 1/18, H01R 13/6581

(54) **ELEKTRISCHE STECKKUPPLUNGSVORRICHTUNG**
ELECTRICAL PLUG COUPLING DEVICE
RACCORD ENFICHABLE ELECTRIQUE

(43) Veröffentlichungstag der Anmeldung: 18.10.2017
(73) Patentinhaber: MD Elektronik GmbH, 84478 Waldkraiburg (DE)
(72) Erfinder: ENGL, Rudolf, 84539 Ampfing (DE)
(74) Vertreter: Hofmann, Ernst

(56) Entgegenhaltungen:
- WO-A1-94/07284
- DE-A1-102007 048 159
- DE-U1-202004 012 318
- US-A- 5 797 771
- US-A1- 2014 073 186

## Beschreibung

Die Erfindung betrifft eine elektrische Steckkupplungsvorrichtung gemäß dem Anspruch 1, welche insbesondere als Teil eines konfektionierten Kabels zur Übertragung von elektrischen Strömen oder Spannungen geeignet ist.

### GEBIET DER TECHNIK

Die betreffenden elektrischen Steckkupplungsvorrichtungen sind etwa im Zusammenhang mit Kabeln in Kraftfahrzeugen oder Luftfahrzeugen einsetzbar und werden meist in großen Stückzahlen benötigt. Zur kostengünstigen Bereitstellung entsprechender Kabel sind ein einfacher Aufbau und eine einfache Konfektionierbarkeit der elektrischen Steckkupplungsvorrichtungen von großer Bedeutung. Derartige Kabel müssen prozesssicher mit hoher Präzision hergestellt sein wie dies zum Beispiel für eine qualitativ hochwertige Signalübertragung erforderlich ist. Zusätzlich unterliegen die Kabel hohen Anforderungen im Hinblick auf Robustheit. Zudem ist es wichtig, dass die Steckkupplungsvorrichtungen durch die innerhalb der Steckkupplungsvorrichtungen erzeugte Abwärme thermisch nicht zu stark belastet werden.

### STAND DER TECHNIK

Aus der Offenlegungsschrift US 2016/0064873 A1 ist eine Steckkupplungsvorrichtung bekannt, die eine Leiterplatte in einem Gehäuse aufweist. Die im Gehäuse entstehende Wärme wird berührungslos durch ineinander greifende Lamellen an das Gehäuse geleitet.

Die Offenlegungsschrift US 2014/0073186 A1 offenbart eine Steckkupplungsvorrichtung mit einem eine Leiterplatte umschließenden Gehäuseteil, durch welches insbesondere eine gute elektromagnetische Abschirmung für die auf der Leiterplatte montierten elektronischen Bauteile erreicht werden soll.

In der DE 20 2004 012 318 U1 ist ein Gehäuse gezeigt, welches eine Leiterplatte umschließt. Zur Ableitung von Wärme sind Wärmeableitelemente vorgesehen, die die Wärme an eine innerhalb des Gehäuses angeordnete Wärmeaufnahmefläche weiterleiten, so dass schließlich die Wärme über das thermisch leitfähige Gehäuse abfließen kann.

### ZUSAMMENFASSUNG DER ERFINDUNG

Der Erfindung liegt die Aufgabe zugrunde, eine elektrische Steckkupplungsvorrichtung zu schaffen, welche vor übermäßiger Eigenerwärmung geschützt ist und dennoch mit relativ geringem Herstellungsaufwand fertigbar ist.

Diese Aufgabe wird erfindungsgemäß durch die Merkmale des Anspruches 1 gelöst.

Erfindungsgemäß umfasst die elektrische Steckkupplungsvorrichtung ein Gehäuse und eine Leiterplatte, wobei das Gehäuse mit der Leiterplatte durch eine Fügenaht verbunden ist. Das Gehäuse ist thermisch leitfähig und insbesondere auch elektrisch leitfähig ausgestaltet und weist eine Öffnung auf. Auf der Leiterplatte sind elektronische Bauteile angeordnet und an der Leiterplatte ist weiterhin zumindest ein Steckkontakt angeordnet. Der zumindest eine Steckkontakte kann ein Pin beziehungsweise ein Kontaktstift oder eine Kontaktöffnung beziehungsweise eine Buchse sein. Die Leiterplatte weist zumindest eine Fügefläche auf, die insbesondere an einem Rand der Leiterplatte angeordnet sein kann. Die Steckkupplungsvorrichtung ist so ausgestaltet, dass das Gehäuse die Leiterplatte umgibt, so dass die Innenseite des Gehäuses den elektronischen Bauteilen zugewandt ist. Die Fügenaht ist zwischen der Fügefläche und dem Gehäuse angeordnet, wobei die Fügenaht an der Außenseite der Steckkupplungsvorrichtung hergestellt ist beziehungsweise von der Außenseite her hergestellt ist. Die Anordnung ist so ausgestaltet, dass die Öffnung zumindest teilweise durch die Fügenaht geschlossen ist. Dabei kann die Leiterplatte beziehungsweise der Rand der Leiterplatte durch die Öffnung hindurch ragen, so dass der Spalt zwischen der Leiterplatte und dem Gehäuse und damit die Öffnung durch die Fügenaht geschlossen ist.

Die Fügenaht ist also unmittelbar mit der Fügefläche der Leiterplatte und dem Gehäuse in Kontakt.

Die Definition, wonach die Fügenaht an der Außenseite der Steckkupplungsvorrichtung hergestellt ist bedeutet insbesondere, dass der Fügeprozess so durchgeführt wurde, dass die Fügenaht von der Außenseite der Steckkupplungsvorrichtung her aufgebaut worden ist. Die Fügenaht kann dabei bezüglich der äußeren Oberfläche des Gehäuses erhaben ausgestaltet sein oder aber von außen zugänglich innerhalb der Öffnung angeordnet sein. Beide Arten der genannten Ausgestaltung schließen a priori eine vorhergegangene Herstellung der Fügenaht an der Außenseite der Steckkupplungsvorrichtung nicht aus.

Mit Vorteil weist die Leiterplatte zwei Fügeflächen auf und der zumindest eine Steckkontakt ist parallel zu einer Achse ausgerichtet, wobei die Fügeflächen bezüglich einer orthogonal zur Achse orientierten Richtung versetzt angeordnet sind. Im Hinblick auf die Anordnung des Steckkontakts ist die Parallelität zur Achse so zu verstehen, dass die Steckkupplungsvorrichtung in dieser Richtung bei bestimmungsgemäßer Bedienung zu betätigen ist. Folglich kann ein Kontakt der Steckkupplungsvorrichtung mit einem entsprechenden Gegenstück durch Schieben beziehungsweise Ziehen in Richtung parallel zur Achse hergestellt beziehungsweise unterbrochen werden.

Wenn die Leiterplatte zwei Fügeflächen aufweist, sind vorteilhaft die elektronischen Bauteile auf der Leiterplatte zwischen den Fügeflächen angeordnet. Dementsprechend würde eine geometrische Verbindungslinie zwischen den Fügeflächen die elektronischen Bauteile schneiden.

In vorteilhafter Bauweise bilden die Fügefläche und die Fügenaht einen so genannten Fügebereich, welcher in der Öffnung des Gehäuses angeordnet ist. Der Fügebereich kann vollständig oder nur teilweise in der Öffnung des Gehäuses angeordnet sein. Folglich befinden sich innerhalb der Öffnung des Gehäuses sowohl die Fügefläche als auch die Fügenaht zumindest jeweils teilweise.

Mit Vorteil ist die Öffnung als eine Ausnehmung mit einer umlaufenden Berandung ausgestaltet. Demnach kann die Ausnehmung eine geschlossene umlaufende Berandung aufweisen, beispielsweise kann die Ausnehmung durch ausstanzen aus einer Wand des Gehäuses erzeugt werden. Alternativ kann die Öffnung auch zwischen Teilen eines mehrteilig ausgeführten Gehäuses erzeugt sein.

Insbesondere wenn die Öffnung als eine Ausnehmung mit einer umlaufenden Berandung ausgestaltet ist, kann die Fügenaht umlaufend ausgestaltet sein, insbesondere entlang der Kontur der Berandung verlaufen.

In weiterer Ausgestaltung der Erfindung weist die Öffnung in einer Richtung parallel zur Achse ihre größte Ausdehnung auf, wobei die Achse parallel zu dem zumindest einen Steckkontakt ausgerichtet ist. Bei dieser Ausgestaltung kann die Öffnung als Schlitz parallel zur Achse bezeichnet werden.

Wenn die Öffnung mit einer umlaufenden Berandung ausgestaltet ist, können die über den zumindest einen Steckkontakt auf die Leiterplatte eingeleiteten Kräfte, die bei der Herstellung beziehungsweise bei der Unterbrechung des Kontakts mit einem entsprechenden Gegenstück auftreten und die parallel zur Achse gerichtet sind, formschlüssig an das Gehäuse abgeleitet werden.

Mit Vorteil weist das Gehäuse beziehungsweise der Werkstoff, aus dem das Gehäuse hergestellt ist, eine Wärmeleitfähigkeit von mindestens 10 W/(m·K), insbesondere eine Wärmeleitfähigkeit von mindestens 25 W/(m·K) auf. Insbesondere kann das Gehäuse aus einem Metallwerkstoff bestehen.

In vorteilhafter Bauweise ist die Fügenaht als eine Lötnaht ausgestaltet, wobei die Fügefläche eine Oberfläche einer metallischen Schicht auf der Leiterplatte darstellt. Insbesondere kann die Fügefläche als ein Lötpad hergestellt sein. In weiterer Ausgestaltung der Erfindung kann die Fügenaht durch einen Wellenlötprozess beziehungsweise Schwalllötprozess hergestellt sein.

Mit Vorteil weist die Leiterplatte im Bereich der Fügefläche zumindest eine metallisierte Bohrung auf. Die metallisierte Bohrung kann als Durchkontaktierung beziehungsweise als Via hergestellt ein. Somit kann also die Fügefläche als ein Lötpad mit einer oder mehreren Durchkontaktierungen ausgestaltet sein. Insbesondere ist die Leiterplatte so ausgestaltet, dass die Bohrung die Fügefläche durchdringt, so dass also ein Loch in der Fügefläche vorliegt.

Sofern die Leiterplatte im Bereich der Fügefläche mehrere metallisierte Bohrungen aufweist, sind mit Vorteil die Bohrungen in einer Richtung parallel zur Achse aneinandergereiht. In diesem Fall kann dann die Leiterplatte folglich so ausgestaltet sein, dass die mehreren Bohrungen die Fügefläche durchdringen.

Alternativ zum Löten kann als Fügeprozess auch ein Schweißprozess oder ein Klebeprozess angewendet werden. Wobei dann als Fügenaht entsprechend eine Schweißnaht beziehungsweise eine Klebenaht vorliegt. Im Falle einer Klebenaht ist es vorteilhaft, wenn der Kleber eine vergleichsweise hohe thermische Leitfähigkeit aufweist und zum Beispiel thermisch leitfähige Füllstoffe aufweist.

In vorteilhafter Bauweise ist die Leiterplatte mehrlagig ausgestaltet und weist zumindest eine thermisch leitfähige Lage auf. Üblicherweise weist eine derartige mehrlagige Leiterplatte mehrere isolierende Lagen und eine oder mehrere thermisch leitfähige Lagen auf.

In weiterer Ausgestaltung der Erfindung ist eine Fügefläche sowohl auf der Ober- als auch auf der Unterseite der Leiterplatte jeweils gegenüber liegend angeordnet.

Erfindungsgemäß ist die Leiterplatte so ausgestaltet, dass die Fügefläche mit einem Überstand bezüglich einer orthogonal zur Achse orientierten Richtung auf der Leiterplatte angeordnet ist. Mit anderen Worten kann an der Längsseite der Leiterplatte ein Überstand angeordnet beziehungsweise herausgearbeitet sein, auf dem eine oder mehrere Fügeflächen angeordnet sind.

Wenn die Leiterplatte mehrere Fügeflächen aufweist, so kann diese so ausgestaltet sein, dass die genannten Merkmale bezüglich der einen Fügefläche für die mehreren Fügeflächen zutreffen. Folglich kann das Gehäuse mehrere Öffnungen aufweisen und die Leiterplatte kann mehrere Fügeflächen aufweisen, die insbesondere jeweils an einem Rand der Leiterplatte angeordnet sein können. Die Fügenähte sind dann jeweils zwischen einer der Fügefläche und dem Gehäuse angeordnet, wobei jede Fügenaht an der Außenseite der Steckkupplungsvorrichtung hergestellt ist. Zudem ist dann die zugehörige Öffnung zumindest teilweise durch die jeweilige Fügenaht geschlossen.

Durch die elektrische Steckkupplungsvorrichtung kann die durch die elektronischen Bauteile erzeugte Wärme wirksam nach außen abgegeben werden. Zudem weist die elektrische Steckkupplungsvorrichtung sehr gute Eigenschaften im Hinblick auf die Abschirmung von elektromagnetischer Störstrahlung auf.

Vorteilhafte Ausbildungen der Erfindung entnimmt man den abhängigen Ansprüchen.

Weitere Einzelheiten und Vorteile der erfindungsgemäßen Steckkupplungsvorrichtung ergeben sich aus der nachfolgenden Beschreibung eines Ausführungsbeispiels anhand der beiliegenden Figuren.

### KURZE BESCHREIBUNG DER ZEICHNUNGEN

Es zeigen die
- Figur 1: eine perspektivische Ansicht einer Leiterplatte für eine elektrische Steckkupplungsvorrichtung,
- Figur 2: eine Draufsicht auf die Leiterplatte,
- Figur 3: eine Detailansicht eines Randes der Leiterplatte in einer Schnittdarstellung C - C,
- Figur 4: eine perspektivische Ansicht eines Gehäuses,
- Figur 5: eine perspektivische Ansicht der Leiterplatte in einem Montagezustand, in welchem das Gehäuse die Leiterplatte umgibt,
- Figur 6: eine perspektivische Ansicht der Leiterplatte mit dem Gehäuse nach dem Fügen,
- Figur 7: eine Detailansicht eines Randes der Leiterplatte sowie des Gehäuses in einer Schnittdarstellung C - C,
- Figur 8: eine perspektivische Ansicht der elektrischen Steckkupplungsvorrichtung.

### BESCHREIBUNG DER AUSFÜHRUNGSFORMEN

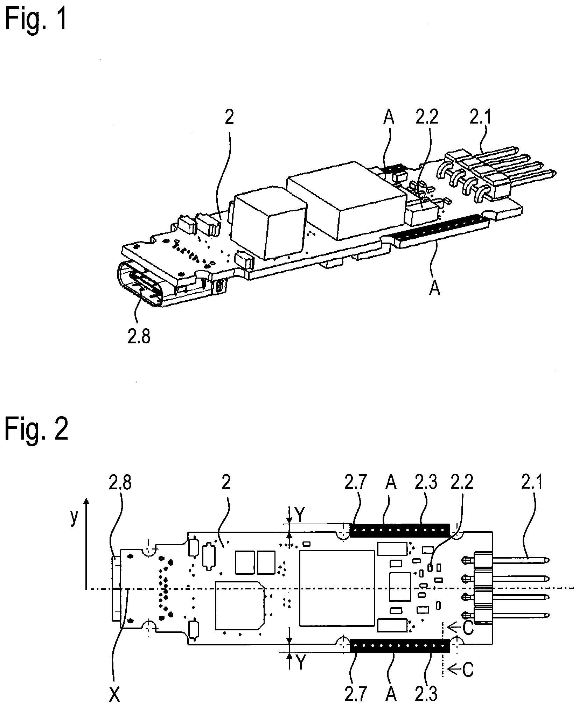

Die im vorgestellten Ausführungsbeispiel beschriebene elektrische Steckkupplungsvorrichtung umfasst eine Leiterplatte 2 gemäß den Figuren 1 und 2. Zur Herstellung einer elektrischen Verbindung mit einem Gegenstück der Steckkupplungsvorrichtung sind an der Leiterplatte 2 Steckkontakte 2.1, beispielsweise Pins angeordnet beziehungsweise moniert. Die Orientierung der Steckkontakte 2.1 ist derart, dass diese parallel zu einer Achse X ausgerichtet sind. Die Steckkontakte 2.1 sind elektrisch mit einer Schaltung verbunden, die elektronische Bauteile 2.2 umfasst, wobei die Bauteile 2.2 auf der Leiterplatte 2 angeordnet sind beziehungsweise die Leiterplatte 2 mit den elektronischen Bauteilen 2.2 bestückt ist. Weiterhin umfasst die Leiterplatte 2 einen Eingangskontakt 2.8, welcher mit Leitungen eines Kabels verbindbar ist.

Die Leiterplatte 2 weist jeweils an einer Längsseite einen Rand A, wobei die betreffenden Ränder A beidseitig bezüglich der Achse X beziehungsweise beidseitig bezüglich der elektronischen Bauteile 2.2 angeordnet sind. An den Rändern A sind an der Ober- als auch an der Unterseite der Leiterplatte 2 gegenüberliegend jeweils Fügeflächen 2.3 aufgebracht, die im vorgestellten Ausführungsbeispiel als metallische Schichten ausgestaltet sind. Die Fügeflächen 2.3 sind also bezüglich einer orthogonal zur Achse X orientierten Richtung y versetzt angeordnet, wobei die elektronischen Bauteile 2.2 auf der Leiterplatte 2 zwischen den Fügeflächen 2.3 angeordnet sind.

Die Leiterplatte 2 ist so ausgestaltet, dass die Fügeflächen 2.3 jeweils mit einem Überstand Y bezüglich der Richtung y auf der Leiterplatte 2 angeordnet sind. Insbesondere sind die Fügeflächen 2.3 an der breitesten Stelle der Leiterplatte 2 und an den Rändern A der Leiterplatte 2 angeordnet, wobei sich die Achse X in Längsrichtung erstreckt (senkrecht zur Erstreckungsrichtung in die Breite beziehungsweise senkrecht zur Richtung y).

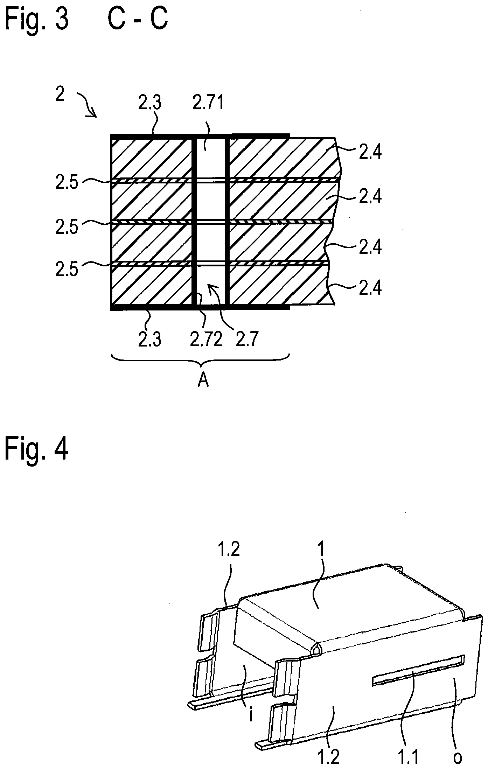

Die Leiterplatte 2 weist an den betreffenden Rändern A Bohrungen 2.7, die hier als Durchkontaktierungen ausgestaltet sind, auf. Diese umfassen gemäß der Figur 3 jeweils einen Hohlraum 2.71, dessen Wandung eine metallische Schicht 2.72 aufweist. Die metallisierten Bohrungen 2.7 sind entlang einer Richtung parallel zur Achse X aneinandergereiht.

In der Figur 3 ist ein Rand A gemäß dem Schnitt C - C in Figur 2 dargestellt. Die Leiterplatte 2 umfasst demnach mehrere isolierende Lagen 2.4, insbesondere mehrere Prepreg-Lagen, sowie mehrere thermisch leitfähige Lagen 2.5, die beispielsweise aus einer Kupferlegierung hergestellt sein können. Aus der Figur 3 ist zudem ersichtlich, dass im vorgestellten Ausführungsbeispiel im Bereich des jeweiligen Randes A die Fügeflächen 2.3 auf der Ober- und auf der Unterseite der Leiterplatte 2 aufgebracht sind. Alternativ oder ergänzend zu dieser Bauweise könnte auf der Stirnfläche, in der Figur 3 links, eine Fügefläche aufgebracht werden.

Ferner umfasst die elektrische Steckkupplungsvorrichtung ein thermisch und elektrisch leitfähiges Gehäuse 1 gemäß der Figur 4. Im vorgestellten Ausführungsbeispiel ist dieses als einstückiges Blechbauteil aus Stahl hergestellt. Das Gehäuse 1 ist so ausgestaltet, insbesondere gebogen, dass dessen Querschnitt in erster Näherung eine U-Form mit zwei Schenkeln 1.2 aufweist. Dementsprechend weist das Gehäuse 1 eine Innenseite i, die nach erfolgter Montage zur Leiterplatte 2 hin orientiert ist und eine Außenseite o auf. Das Gehäuse 1 weist zwei Öffnungen 1.1 auf, die hier als Ausnehmungen insbesondere als Schlitzte ausgestaltet sind, so dass die jeweilige Öffnungen 1.1 eine umlaufende Berandung aufweist. Insbesondere weisen hier jeweils die Schenkel 1.2 des Gehäuses 1 die Öffnungen 1.1 auf.

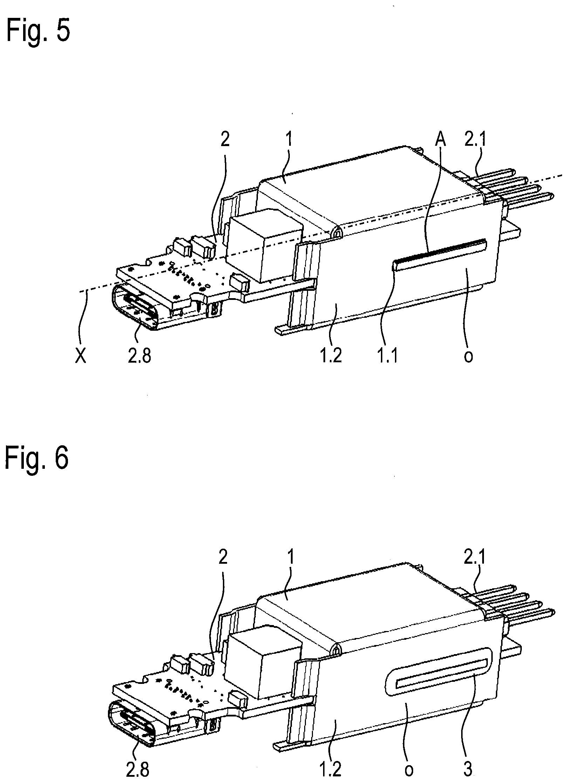

Im Zuge der Montage der Steckkupplungsvorrichtung werden die Schenkel 1.2 leicht auseinandergebogen, so dass die Leiterplatte 2 in das Gehäuse 1 eingeführt werden kann. Dabei werden die Ränder A der Leiterplatte 2 entsprechend der Figur 5 in die Öffnungen 1.1 des Gehäuses 1 gebracht, so dass die Ränder A durch die Öffnung 1.1 hindurch ragen. In dieser Position sind sowohl die Bohrungen 2.7 als auch zumindest Teile der Fügeflächen 2.3 in den Öffnungen 1.1 angeordnet, so dass die Bohrungen 2.7 zumindest teilweise durch die Wandung des Gehäuses 1 abgedeckt werden. Die Öffnungen 1.1 sind als in Längsrichtung verlaufende Ausnehmungen ausgestaltet, so dass diese parallel zur Achse X ausgerichtet sind und in dieser Richtung parallel zur Achse X ihre größte Ausdehnung aufweisen. Die Öffnungen 1.1 sind beidseitig der Achse X und zudem parallel zu den Steckkontakten 2.1 angeordnet. Sobald die Schenkel wieder entspannt sind, ist die Leiterplatte 2 im Gehäuse 1 festgelegt, wobei das Gehäuse 1 die Leiterplatte 2 umgibt.

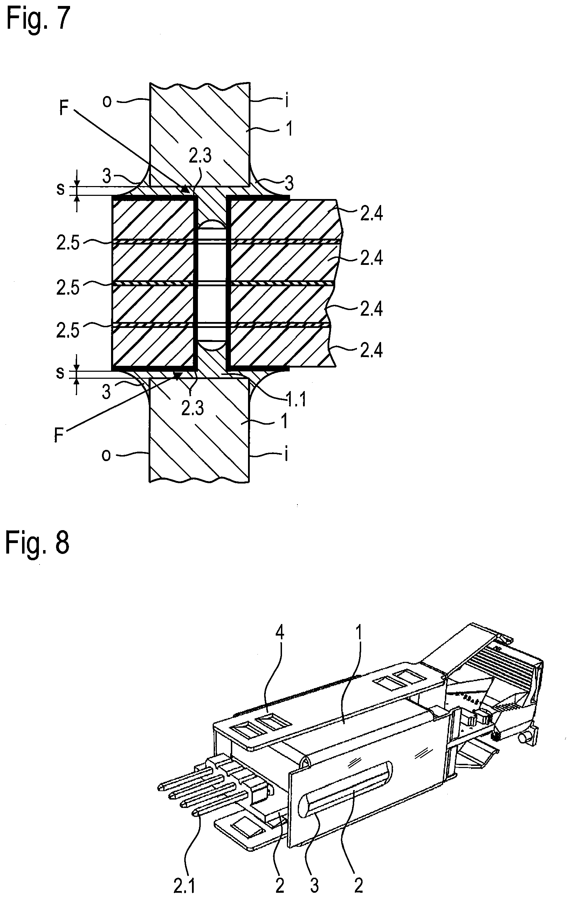

Im weiteren Fortgang des Herstellungsprozesses können das Gehäuse 1 und die Leiterplatte 2 gefügt, also dauerhaft miteinander verbunden, werden. Die Steckkupplungsvorrichtung wird von der Außenseite o her gefügt. Im vorgestellten Ausführungsbeispiel kommt als Fügetechnologie ein Lötprozess zur Anwendung. Insbesondere werden das Gehäuse 1 und die Leiterplatte 2 durch ein Schwalllötverfahren beziehungsweise durch Wellenlöten miteinander verbunden. Zu diesem Zweck wird das Gehäuse 1 und die darin festgelegte Leiterplatte 2 gemäß der Figur 5 so gedreht, dass die Schenkel 1.2 waagrecht liegen. In dieser Stellung wird die Anordnung in einer Lötanlage gefügt, wobei der Rand A der Leiterplatte 2 sowie ein zugehöriger Schenkel 1.2 des Gehäuses 1 über eine Lötwelle gefahren werden. Im Ergebnis entsteht, wie in der Figur 7 dargestellt, eine Fügenaht 3, die hier als Lötnaht bezeichnet werden kann. Die Fügenaht 3 erstreckt sich infolge der beim Lötprozess vorliegenden Benetzungseigenschaften über die gesamte Fügefläche 2.3.

Die Fügenaht 3 ist auf diese Weise an der Außenseite o der Steckkupplungsvorrichtung hergestellt, wobei ein Spalt s zwischen der Wand des Gehäuses 1 im Bereich der Öffnung 1.1 und der Leiterplatte 2 beziehungsweise der Fügeflächen 2.3 durch die Fügenaht 3 geschlossen ist, so dass also letztlich die Öffnung 1.1 durch die Fügenaht 3 geschlossen ist. Zudem füllt die Fügenaht 3 zumindest jeweils einen Teil der Bohrungen 2.7 beziehungsweise der Hohlräume 2.71 aus. Außerdem ist die Fügenaht 3 mit dem Gehäuse 1 in Kontakt insbesondere ist die Fügenaht 3 umlaufend ausgestaltet, entlang der Berandung in der Öffnung 1.1. Die Fügefläche 2.3 und die Fügenaht 3 bilden einen Fügebereich F. Dabei ist der Fügebereich F teilweise in der Öffnung 1.1 des Gehäuses 1 angeordnet, beziehungsweise sind die Fügefläche 2.3 und die Fügenaht 3 jeweils teilweise in der Öffnung 1.1 des Gehäuses 1 angeordnet.

Nachdem auf diese Weise einer der Ränder A der Leiterplatte 2 beziehungsweise ein Paar der Fügeflächen 2.3 mit dem Gehäuse 1 verbunden ist, wird die Leiterplatte 2 mit dem Gehäuse 1 um 180° gedreht, so dass die zu fügende zweite Fläche unten zu liegen kommt und auf die gleiche Weise gefügt wird wie die erste Verbindung.

In der Figur 6 ist eine entsprechende Steckkupplungsvorrichtung gezeigt, wobei an der Außenseite o des Gehäuses 1 die Fügenaht 3 erkennbar ist.

Um die elektrische Steckkupplungsvorrichtung kann ein elektrisch isolierendes Umgehäuse 4 montiert werden, so dass danach eine Anordnung gemäß der Figur 8 vorliegt.

Im vorgestellten Ausführungsbeispiel ragen die Ränder A der Leiterplatte 2 durch die Öffnung 1.1 hindurch. Alternativ kann die Leiterplatte bündig oder zumindest ohne Überstand in der Öffnung 1.1 des Gehäuses 1 angeordnet sein. Auch bei diesen alternativen Ausführungsformen ist es vorteilhaft, wenn die Fügenaht 3 an der Außenseite o der Steckkupplungsvorrichtung hergestellt ist, so dass die Öffnung 1.1, beziehungsweise ein Spalt s zwischen Gehäuse 1 und Leiterplatte 1, zumindest teilweise durch die Fügenaht 3 geschlossen ist.

Die elektrische Steckkupplungsvorrichtung wird bestimmungsgemäß mit einer elektrischen Leitung verbunden, so dass ein konfektioniertes Kabel hergestellt ist. Derartige Kabel dienen üblicherweise zur Übertragung von elektrischer Energie und / oder Signalen. Das Kabel ist insbesondere zum Einbau in einem Fahrzeug bestimmt und ist gemäß dem Ausführungsbeispiel ungeschirmt ausgestaltet. Durch die Steckkupplungsvorrichtung kann das Kabel an einem Ende lösbar mit einem entsprechenden Gegenstück einer anderen Komponente, beispielsweise einem Element einer Bordelektronik im Sinne einer Steckverbindung verbunden werden.

Im Betrieb des Kabels erzeugen die elektronischen Bauteile 2.2 Verlustwärme, die zum Teil über die thermisch leitfähigen Lagen 2.5 der mehrlagigen Leiterplatte 2 zu den Rändern A hin abfließen kann. Insbesondere, wenn wie im vorgestellten Ausführungsbeispiel das Kabel keinen Schirm aufweist, kann die entstehende Wärme nicht über den Schirm abgeleitet werden. Durch die vorliegende Bauweise wird die Abwärme über die metallischen Schichten 2.72 der Bohrungen 2.7 und über die Fügeflächen 2.3 zur Fügenaht 3 geleitet und schließlich zum Gehäuse 1. Das Gehäuse 1 kann einerseits durch seine große Oberfläche und andererseits durch seine vergleichsweise hohe Wärmeleitfähigkeit die entstandene Abwärme gut an die Umgebung abführen. Auf diese Weise kann eine übermäßige thermische Belastung der Leiterplatte 2 vermieden werden.

Schließlich wird durch die erfindungsgemäße Steckkupplungsvorrichtung eine hervorragende EMV-Dichtigkeit erreicht, so dass die Steckkupplungsvorrichtung kaum störende elektromagnetische Strahlung emittiert und gegen auftretende elektromagnetische Strahlung von außen unempfindlich ist.

## Patentansprüche

1. Elektrische Steckkupplungsvorrichtung umfassend ein Gehäuse (1) und eine Leiterplatte (2), wobei das Gehäuse (1) mit der Leiterplatte (2) durch eine Fügenaht (3) verbunden ist, wobei
- das Gehäuse (1) thermisch leitfähig ausgestaltet ist und eine Öffnung (1.1) aufweist,
- die Leiterplatte, elektronische Bauteile (2.2), zumindest einen Steckkontakt (2.1) und zumindest eine Fügefläche (2.3) aufweist, wobei
die Steckkupplungsvorrichtung so ausgestaltet ist, dass das Gehäuse (1) die Leiterplatte (2) umgibt, **dadurch gekennzeichnet dass** die Fügenaht (3) zwischen der Fügefläche (2.3) und dem Gehäuse (1) angeordnet ist, wobei die Fügenaht (3) an der Außenseite (o) der Steckkupplungsvorrichtung hergestellt ist, so dass die Öffnung (1.1) zumindest teilweise durch die Fügenaht (3) geschlossen ist, wobei
der zumindest eine Steckkontakt (2.1) parallel zu einer Achse (X) ausgerichtet ist und die Leiterplatte (2) so ausgestaltet ist, dass die Fügefläche (2.3) mit einem Überstand (Y) bezüglich einer orthogonal zur Achse (X) orientierten Richtung (y) auf der Leiterplatte (2) angeordnet ist.

2. Elektrische Steckkupplungsvorrichtung gemäß dem Anspruch 1, wobei die Leiterplatte (2) zwei Fügeflächen (2.3) aufweist, die bezüglich der orthogonal zur Achse (X) orientierten Richtung (y) versetzt angeordnet sind.

3. Elektrische Steckkupplungsvorrichtung gemäß dem Anspruch 1 oder 2, wobei die Leiterplatte (2) zwei Fügeflächen (2.3) aufweist und die elektronischen Bauteile (2.2) auf der Leiterplatte (2) zwischen den Fügeflächen (2.3) angeordnet sind.

4. Elektrische Steckkupplungsvorrichtung gemäß einem der vorhergehenden Ansprüche, wobei die Fügefläche (2.3) und die Fügenaht (3) einen Fügebereich (F) bilden und der Fügebereich (F) in der Öffnung (1.1) des Gehäuses (1) angeordnet ist.

5. Elektrische Steckkupplungsvorrichtung gemäß einem der vorhergehenden Ansprüche, wobei die Öffnung (1.1) als eine Ausnehmung mit einer umlaufenden Berandung ausgestaltet ist.

6. Elektrische Steckkupplungsvorrichtung gemäß einem der vorhergehenden Ansprüche, wobei die Fügenaht (3) umlaufend ausgestaltet ist.

7. Elektrische Steckkupplungsvorrichtung gemäß einem der vorhergehenden Ansprüche, wobei die Öffnung (1.1) in einer Richtung parallel zur Achse (X) ihre größte Ausdehnung aufweist.

8. Elektrische Steckkupplungsvorrichtung gemäß einem der vorhergehenden Ansprüche, wobei das Gehäuse (1) aus einem Werkstoff hergestellt ist, welcher ein Metall umfasst.

9. Elektrische Steckkupplungsvorrichtung gemäß einem der vorhergehenden Ansprüche, wobei die Fügenaht (3) als eine Lötnaht ausgestaltet ist und die Fügefläche (2.3) eine Oberfläche einer metallischen Schicht auf der Leiterplatte (2) darstellt.

10. Elektrische Steckkupplungsvorrichtung gemäß dem Anspruch 9, wobei die Fügenaht (3) durch einen Wellenlötprozess hergestellt ist.

11. Elektrische Steckkupplungsvorrichtung gemäß einem der vorhergehenden Ansprüche, wobei die Leiterplatte (2) im Bereich der Fügefläche (2.3) zumindest eine metallisierte Bohrung (2.7) aufweist, wobei die Leiterplatte (2) so ausgestaltet ist, dass die zumindest eine Bohrung (2.7) die Fügefläche (2.3) durchdringt, so dass ein Loch in der Fügefläche (2.3) vorliegt.

12. Elektrische Steckkupplungsvorrichtung gemäß einem der vorhergehenden Ansprüche, wobei die Leiterplatte (2) im Bereich der Fügefläche (2.3) mehrere metallisierte Bohrungen (2.7) aufweist, wobei die Bohrungen (2.7) in einer Richtung parallel zur Achse (X) aneinandergereiht sind, wobei die Leiterplatte (2) so ausgestaltet ist, dass die mehreren Bohrung (2.7) die Fügefläche (2.3) durchdringen, so dass jeweils ein Loch in der Fügefläche (2.3) vorliegt.

13. Elektrische Steckkupplungsvorrichtung gemäß einem der vorhergehenden Ansprüche, wobei die Leiterplatte (2) mehrlagig ausgestaltet ist und zumindest eine thermisch leitfähige Lage (2.5) aufweist.

14. Elektrische Steckkupplungsvorrichtung gemäß einem der vorhergehenden Ansprüche, wobei sowohl auf der Ober- als auch auf der Unterseite der Leiterplatte (2) eine Fügefläche (2.3) angeordnet ist.

## Claims

1. Electrical plug coupling apparatus comprising a housing (1) and a printed circuit board (2), wherein the housing (1) is connected to the printed circuit board (2) by a joining seam (3), wherein
- the housing (1) is of thermally conductive design and has an opening (1.1),
- the printed circuit board has electronic components (2.2), at least one plug contact (2.1) and at least one joining area (2.3), wherein
the plug coupling apparatus is designed such that the housing (1) surrounds the printed circuit board (2), **characterized in that** the joining seam (3) is arranged between the joining area (2.3) and the housing (1), wherein the joining seam (3) is produced on the outside (o) of the plug coupling apparatus, so that the opening (1.1) is at least partially closed by the joining seam (3), wherein
the at least one plug contact (2.1) is oriented parallel to an axis (X) and the printed circuit board (2) is designed such that the joining area (2.3) is arranged on the printed circuit board (2) with an excess length (Y) with respect to a direction (y) which is oriented orthogonally in relation to the axis (X).

2. Electrical plug coupling apparatus according to Claim 1, wherein the printed circuit board (2) has two joining areas (2.3) which are arranged offset with respect to the direction (y) which is oriented orthogonally in relation to the axis (X).

3. Electrical plug coupling apparatus according to Claim 1 or 2, wherein the printed circuit board (2) has two joining areas (2.3), and the electronic components (2.2) are arranged between the joining areas (2.3) on the printed circuit board (2).

4. Electrical plug coupling apparatus according to one of the preceding claims, wherein the joining area (2.3) and the joining seam (3) form a joining region (F) and the joining region (F) is arranged in the opening (1.1) in the housing (1).

5. Electrical plug coupling apparatus according to one of the preceding claims, wherein the opening (1.1) is designed as a recess with a peripheral boundary.

6. Electrical plug coupling apparatus according to one of the preceding claims, wherein the joining seam (3) is formed over the periphery.

7. Electrical plug coupling apparatus according to one of the preceding claims, wherein the opening (1.1) has its greatest extent in a direction parallel to the axis (X).

8. Electrical plug coupling apparatus according to one of the preceding claims, wherein the housing (1) is produced from a material which comprises a metal.

9. Electrical plug coupling apparatus according to one of the preceding claims, wherein the joining seam (3) is designed as a solder seam, and the joining area (2.3) constitutes a surface of a metal layer on the printed circuit board (2).

10. Electrical plug coupling apparatus according to Claim 9, wherein the joining seam (3) is produced by a wave soldering process.

11. Electrical plug coupling apparatus according to one of the preceding claims, wherein the printed circuit board (2) has at least one metallized bore (2.7) in the region of the joining area (2.3), wherein the printed circuit board (2) is designed such that the at least one bore (2.7) passes through the joining area (2.3), with the result that there is a hole in the joining area (2.3).

12. Electrical plug coupling apparatus according to one of the preceding claims, wherein the printed circuit board (2) has a plurality of metallized bores (2.7) in the region of the joining area (2.3), wherein the bores (2.7) are lined up with one another in a direction parallel to the axis (X), wherein the printed circuit board (2) is designed such that the plurality of bores (2.7) pass through the joining area (2.3), with the result that there is a hole in the joining area (2.3) in each case.

13. Electrical plug coupling apparatus according to one of the preceding claims, wherein the printed circuit board (2) is of multilayer design and has at least one thermally conductive layer (2.5).

14. Electrical plug coupling apparatus according to one of the preceding claims, wherein a joining area (2.3) is arranged both on the top side and also on the bottom side of the printed circuit board (2).

## Revendications

1. Dispositif de raccordement électrique enfichable comprenant un boîtier (1) et une carte de circuit imprimé (2), dans lequel le boîtier (1) est relié à la carte de circuit imprimé (2) par un joint d'assemblage (3), dans lequel
- le boîtier (1) est configuré de manière thermiquement conductrice et comporte une ouverture (1.1),
- la carte de circuit imprimé comporte des composants électroniques (2.2), au moins un contact enfichable (2.1) et au moins une surface de jonction (2.3),
dans lequel le dispositif de raccordement enfichable est configuré de manière à ce que le boîtier (1) entoure la carte de circuit imprimé (2), **caractérisé en ce que** le joint d'assemblage (3) est disposé entre la surface de jonction (2.3) et le boîtier (1), dans lequel le joint d'assemblage (3) est réalisé sur la face extérieure (o) du dispositif de raccordement enfichable, de manière à ce que l'ouverture (1.1) soit fermée au moins partiellement par le joint d'assemblage (3),
dans lequel l'au moins un contact enfichable (2.1) est orienté parallèlement à un axe (X) et la carte de circuit imprimé (2) est configurée de manière à ce que la surface de jonction (2.3) soit disposée sur la carte de circuit imprimé (2) avec saillie (Y) par rapport à une direction (y) orientée perpendiculairement à l'axe (X).

2. Dispositif de raccordement électrique enfichable selon la revendication 1, dans lequel la carte de circuit imprimé (2) comporte deux surfaces de jonction (2.3), qui sont disposées de manière décalée par rapport à la direction (y) orientée perpendiculairement à l'axe (X) .

3. Dispositif de raccordement électrique enfichable selon la revendication 1 ou 2, dans lequel la carte de circuit imprimé (2) comporte deux surfaces de jonction (2.3) et les composants électroniques (2.2) sont disposés sur la carte de circuit imprimé (2) entre les surfaces de jonction (2.3).

4. Dispositif de raccordement électrique enfichable selon l'une des revendications précédentes, dans lequel la surface de jonction (2.3) et le joint d'assemblage (3) forment une zone de jonction (F) et la zone de jonction (F) est disposée dans l'ouverture (1.1) du boîtier (1).

5. Dispositif de raccordement électrique enfichable selon l'une des revendications précédentes, dans lequel l'ouverture (1.1) est configurée sous la forme d'un évidement muni d'une bordure circonférentielle.

6. Dispositif de raccordement électrique enfichable selon l'une des revendications précédentes, dans lequel le joint d'assemblage (3) est configuré circonférentiellement.

7. Dispositif de raccordement électrique enfichable selon l'une des revendications précédentes, dans lequel l'ouverture (1.1) présente son extension la plus grande dans une direction parallèle à l'axe (X).

8. Dispositif de raccordement électrique enfichable selon l'une des revendications précédentes, dans lequel le boîtier (1) est réalisé à partir d'un matériau comprenant un métal.

9. Dispositif de raccordement électrique enfichable selon l'une des revendications précédentes, dans lequel le joint d'assemblage (3) est configuré sous la forme d'un joint soudé et la surface de jonction (2.3) représente une surface d'une couche métallique sur la carte de circuit imprimé (2).

10. Dispositif de raccordement électrique selon la revendication 9, dans lequel le joint d'assemblage (3) est réalisé par un processus de soudage à la vague.

11. Dispositif de raccordement électrique enfichable selon l'une des revendications précédentes, dans lequel la carte de circuit imprimé (2) comporte dans la région de la surface de jonction (2.3) au moins un alésage métallisé (2.7), dans lequel la carte de circuit imprimé (2) est configurée de manière à ce que l'au moins un alésage (2.7) traverse la surface de jonction (2.3), afin qu'un orifice soit présent dans la surface de jonction (2.3).

12. Dispositif de raccordement électrique enfichable selon l'une des revendications précédentes, dans lequel la carte de circuit imprimé (2) comporte plusieurs alésages métallisés (2.7) dans la région de la surface de jonction (2.3), dans lequel les alésages (2.7) sont disposés les uns à la suite des autres dans une direction parallèle à l'axe (X), dans lequel la carte de circuit imprimé (2) est configurée de manière à ce que la pluralité d'alésages (2.7) traversent la surface de jonction (2.3), afin qu'un orifice respectif soit présent dans la surface de jonction (2.3).

13. Dispositif de raccordement électrique enfichable selon l'une des revendications précédentes, dans lequel la carte de circuit imprimé (2) est configurée de manière à comporter de multiples couches et comporte au moins une couche thermiquement conductrice (2.5).

14. Dispositif de raccordement électrique enfichable selon l'une des revendications précédentes, dans lequel une surface de jonction (2.3) est disposée à la fois sur la face supérieure et sur la face inférieure de la carte de circuit imprimé (2).
